# FASCICULE DE BREVET EUROPEEN

(11) **EP 2 912 702 B1**
(45) Date de publication et mention de la délivrance du brevet: **18.10.2017**
(21) Numéro de dépôt: 13801612.6
(22) Date de dépôt: 23.10.2013
(51) Int. Cl.: H01L 35/30, H01L 35/32

(54) **CONVERTISSEUR THERMO-ÉLECTRIQUE**
THERMO-ELEKTRISCHER WANDLER
THERMO-ELECTRICAL CONVERTER

(30) Priorité: 23.10.2012 FR 1260095; 03.04.2013 FR 1352991
(43) Date de publication de la demande: 02.09.2015
(73) Titulaire: Airbus Operations, 31060 Toulouse (FR); Airbus, 31700 Blagnac (FR)
(72) Inventeur: TATRY, Philippe, F-31130 Balma (FR); BERHOUET, Sébastien, F-31180 La Salvetat StGilles (FR)
(74) Mandataire: Santarelli
(86) Numéro de dépôt international: PCT/FR2013/052538
(87) Numéro de publication internationale: WO 2014/064386

(56) Documents cités:
- EP-A2- 1 331 838
- EP-A2- 2 475 019
- EP-A2- 2 482 352
- US-A1- 2006 208 492
- US-A1- 2012 073 276

## Description

La présente invention concerne un convertisseur d'énergie pour produire de l'énergie électrique. Elle concerne aussi l'utilisation d'un tel convertisseur dans un aéronef.

Les aéronefs modernes embarquent un nombre important de dispositifs électriques. Ces dispositifs servent au pilotage et à l'instrumentation de l'aéronef et/ou aussi à diverses autres utilisations par l'équipage ou les passagers.

Les dispositifs embarqués peuvent être de natures très variées. Ces dispositifs sont par exemple des capteurs.

Les capteurs sont utilisés pour la surveillance à bord de très nombreux paramètres (température, pression, contraintes mécaniques ou autre). Le nombre de ces paramètres, qu'il s'agisse d'un aéronef d'essai ou d'un aéronef commercial, peut atteindre plusieurs milliers. Ces capteurs sont en outre disposés dans de nombreuses zones de l'aéronef (zones moteurs, pylônes, cargo, cabine, cockpit, cases de train d'atterrissage, ailes, surfaces mobiles, cône arrière, ou autre).

Ces zones peuvent être difficilement accessibles et peuvent poser des problèmes d'installation des capteurs.

En particulier, les capteurs doivent être alimentés électriquement. Typiquement, les capteurs sont alimentés électriquement par un câblage dédié ou par une source électrique autonome à base de piles ou de batteries installée à proximité des capteurs.

Ces deux modes d'alimentation électrique induisent des contraintes pour la conception de l'aéronef, notamment en termes de fabrication, d'installation et de maintenance.

Par exemple, l'alimentation des capteurs par des câblages dédiés a des impacts, notamment sur :
- la masse de l'aéronef : la masse des câblages, des supports de faisceaux, des renforcements structuraux locaux, ou autre, augmentent la masse de l'aéronef, ce qui augmente en conséquence la consommation de carburant de l'aéronef.
- l'installation des capteurs : celle-ci peut s'avérer très complexe en termes de conception, de fabrication, de maintenance (problèmes d'accessibilité des câblages, de tenue à la chaleur aux vibrations, ou autre).

Par exemple encore, l'alimentation des capteurs par des sources de stockage d'énergie électrique (piles, batteries, ou autre) installées localement a des impacts, notamment sur :
- la conception de ces sources de stockage : celles-ci doivent conserver leur capacité de stockage dans les conditions d'environnement sévères de l'aéronef (cycles thermiques chaud/froid, vibrations, ou autre) ;
- les opérations de maintenance : la durée de vie de ces sources de stockage étant limitée dans le temps, il faut prévoir l'accessibilité à ces sources alors que les capteurs associés sont parfois installés dans des zones très peu accessibles, pour les besoins de la mesure.

Les contraintes évoquées ci-dessus s'imposent aux aéronefs dédiés aux lignes commerciales et aussi aux aéronefs dédiés aux essais en vol.

Pour ce dernier type d'aéronef, il existe en plus un objectif d'installation rapide et simple des ensembles capteurs-câblages à des endroits variés en fonction de l'essai à réaliser.

Des problématiques d'installation de dispositifs électriques et de leurs alimentations ont été illustrées en référence à des capteurs. Cependant, ces problématiques peuvent aussi exister pour d'autres types de dispositifs électriques. Ces problématiques peuvent par ailleurs se rencontrer dans d'autres environnements que celui d'un aéronef.

Ainsi, il existe un besoin pour améliorer l'alimentation électrique des dispositifs électriques, notamment des dispositifs embarqués dans les aéronefs.

La présente invention s'inscrit dans ce cadre.

Le document EP 2 475 019 divulgue un générateur électrique comportant un dispositif thermoélectrique produisant de l'électricité à partir d'un gradient de température subi, et un boîtier comportant un matériau à changement de phase.

Un **premier aspect** de l'invention concerne un système de conversion d'énergie comportant :
- une unité de conversion pour convertir de l'énergie thermique en énergie électrique, ladite unité comportant au moins une surface d'échange thermique pour échanger de l'énergie thermique avec au moins une source thermique extérieure, et
- une unité à inertie thermique configurée pour coopérer avec l'unité de conversion pour ralentir un retour à un équilibre thermique de l'unité de conversion lors de l'échange d'énergie thermique, et
- au moins un premier élément de connexion thermique (503) qui est un barreau conducteur en contact thermique avec une première surface d'échange thermique de l'unité de conversion, ledit premier élément étant configuré pour guider un transfert thermique entre une première source thermique extérieure (504) et ladite première surface d'échange thermique.

Un système selon le premier aspect permet de réaliser une source d'alimentation autonome et permet de remplacer les solutions actuelles nécessitant des câblages et/ou des batteries d'alimentation.

Un système selon le premier aspect peut permettre d'alimenter des capteurs, par exemple dans un aéronef.

Ainsi, les performances de l'aéronef peuvent être améliorées grâce au gain de masse offert par la suppression des câblages et/ou des batteries.

En outre, un système selon le premier aspect est facile à installer car il ne nécessite pas de concevoir l'installation du câblage et de ses fixations aux structures, équipements, ou autre.

Un système selon le premier aspect tire avantage des sources d'énergie thermique présentes au sein même de l'aéronef.

L'unité de conversion permet de générer l'énergie électrique et l'unité à inertie thermique permet de maintenir un gradient de température plus longtemps pour générer cette énergie électrique de manière plus durable.

Un système selon le premier aspect opère donc une conversion d'énergie optimale.

La maintenance des systèmes selon le premier aspect est plus simple car ils ne nécessitent pas de câblage complexe d'alimentation électrique.

Les systèmes selon le premier aspect tirent profit des sources thermiques généralement non exploitées pour générer l'énergie d'alimentation de dispositifs électriques.

L'échange thermique entre l'unité de conversion et la source thermique extérieure peut se faire par contact thermique direct ou indirect. Dans le cas du contact thermique indirect, un élément peut être interposé entre la surface d'échange thermique de l'unité de conversion et la surface d'échange thermique de la source thermique extérieure. Par exemple, l'élément interposé comporte une unité à inertie thermique. Dans le cas d'un contact thermique direct, la surface d'échange thermique de l'unité de conversion et la surface d'échange thermique de la source thermique extérieure sont directement en contact thermique (une pâte thermique peut toutefois être utilisée pour favoriser ce contact thermique).

Selon des modes de réalisation, l'unité à inertie thermique comporte un matériau à changement de phase.

Ces matériaux offrent une bonne inertie thermique et permettent de conserver une différence de température pour la génération d'énergie par l'unité de conversion.

Par exemple, l'unité de conversion comporte un circuit à base de semi-conducteurs.

Ainsi, cette unité peut être de dimensions réduites.

Cette unité peut par exemple fonctionner selon l'effet Seebeck.

Selon des modes de réalisation, le système est isolé par une enveloppe de protection, ladite au moins une surface d'échange thermique restant libre pour l'échange thermique.

Ainsi, il est possible de protéger l'unité à inertie thermique de chocs pouvant conduire par exemple le matériau à changement de phase à s'échapper. Le matériau à changement de phase est ainsi confiné.

Par exemple, le système comporte en outre une unité de stockage pour stocker, au moins en partie, l'énergie électrique convertie.

Ainsi, l'énergie générée peut être utilisée même lorsque la différence de température a disparu au sein de l'unité de conversion, après un retour à l'équilibre thermique.

Par exemple encore, le système comporte en outre au moins un premier élément de connexion thermique en contact thermique avec une première surface d'échange thermique de l'unité de conversion, ledit premier élément étant configuré pour guider un transfert thermique entre une première source thermique extérieure et ladite première surface d'échange thermique.

Ainsi, il est possible d'atteindre des sources thermiques éloignées du système ou peu accessibles.

Par exemple, le système comporte en outre au moins un deuxième élément de connexion thermique en contact thermique avec une deuxième surface d'échange thermique de l'unité de conversion, ledit deuxième élément étant configuré pour guider un transfert thermique entre une deuxième source thermique extérieure et ladite deuxième surface d'échange thermique.

Ainsi, il est possible de mettre l'unité de conversion en contact thermique avec deux sources thermiques éloignées ayant des températures très différentes. Cela permet de maximiser la différence de température et donc l'énergie électrique générée.

Selon des modes de réalisation, ladite au moins une surface d'échange est au moins en partie recouverte d'une couche d'interface de conduction thermique avec ladite au moins une source thermique.

Ainsi le contact thermique est optimisé.

Par exemple, ladite couche d'interface comporte une sous-couche de ruban à double surface adhésive.

Ainsi, la fixation est aussi optimisée.

Par exemple, ledit ruban à double surface adhésive est disposé autour d'une sous-couche de matériau de conduction thermique.

Ladite sous-couche de matériau de conduction thermique peut comporter du GAP PAD 3000S.

Lesdites sous-couches de ruban à double surface adhésive et de matériau de conduction thermique ont par exemple une même épaisseur.

Par exemple, lesdites sous-couches de ruban à double surface adhésive et de matériau de conduction thermique sont intégrées dans un même élément d'interface indépendant. Cet élément est par exemple un patch ou une bandelette découpée sur un rouleau.

Un **deuxième aspect** de l'invention concerne un aéronef comportant un système selon le premier aspect.

Par exemple, ladite au moins une source thermique est choisie parmi les éléments de structure de l'aéronef.

Par exemple encore, le système alimente au moins un capteur en énergie électrique.

Un **troisième aspect** de l'invention concerne un procédé d'alimentation électrique d'un dispositif électrique dans un aéronef, comportant les étapes suivantes de :
- sélection d'au moins une source thermique dans l'aéronef,
- mise en contact thermique d'au moins une surface d'échange d'une unité de conversion d'un système selon le premier aspect à ladite au moins une source thermique sélectionnée, et
- connexion dudit système audit dispositif électrique,
ladite mise en contact thermique comportant la mise en contact thermique d'au moins un premier élément de connexion thermique (503) qui est un barreau conducteur avec une première surface d'échange thermique de l'unité de conversion, ledit premier élément étant configuré pour guider un transfert thermique entre une première source thermique extérieure (504) et ladite première surface d'échange thermique.

Par exemple, ladite au moins une source thermique est sélectionnée parmi les éléments de structure de l'aéronef.

Par exemple encore, ladite au moins une source thermique est choisie de manière à optimiser une différence de température au sein de l'unité de conversion du système.

Les objets selon les deuxième et troisième aspects de l'invention procurent au moins les mêmes avantages que ceux procurés par le système selon le premier aspect.

D'autres caractéristiques et avantages de l'invention apparaîtront à la lecture de la présente description détaillée qui suit, à titre d'exemple non limitatif, et des figures annexées parmi lesquelles :
- la **figure 1** illustre schématiquement un système selon des modes de réalisation;
- la **figure 2** illustre un exemple d'installation d'un système selon des modes de réalisation;
- la **figure 3** illustre des zones d'installation dans un aéronef d'un système selon des modes de réalisation;
- les **figures 4, 5a** et **5b** illustrent des modes de réalisation de systèmes de conversion d'énergie;
- la **figure 6** illustre schématiquement le principe général de fonctionnement d'une unité de conversion thermo-électrique selon des modes de réalisation;
- les **figures 7****,** **8a** et **8b** illustrent des unités de conversion thermo-électriques selon des modes de réalisation ;
- la **figure 9** est un organigramme d'étapes de procédés selon des modes de réalisation ; et
- Les **figures 10a-10d** illustrent une interface de montage selon des modes de réalisation.

Dans la suite, il est décrit un système de conversion permettant de transformer l'énergie thermique disponible (habituellement perdue sous forme de chaleur et non utilisée) dans un véhicule, tel qu'un aéronef, en électricité. L'invention ne se limite toutefois pas à une utilisation dans un véhicule ou un aéronef.

Le système comporte une unité de conversion d'énergie comme par exemple un ou plusieurs générateurs thermo-électriques. Cette unité de conversion est couplée à une unité à inertie thermique comportant par exemple un matériau à changement de phase.

L'énergie électrique ainsi générée est par exemple utilisée pour alimenter des capteurs. L'invention peut toutefois être utilisée pour alimenter d'autres types de dispositifs électriques.

Un système tel que décrit dans la suite peut par exemple être installé en lieu et place ou en complément de sources classiques de génération d'énergie électrique.

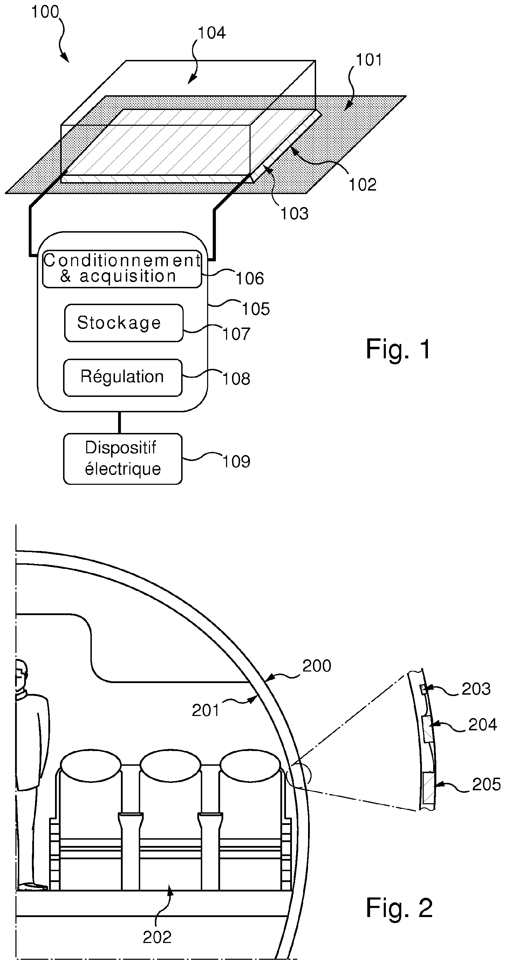

La **figure 1** illustre schématiquement un système selon des modes de réalisation.

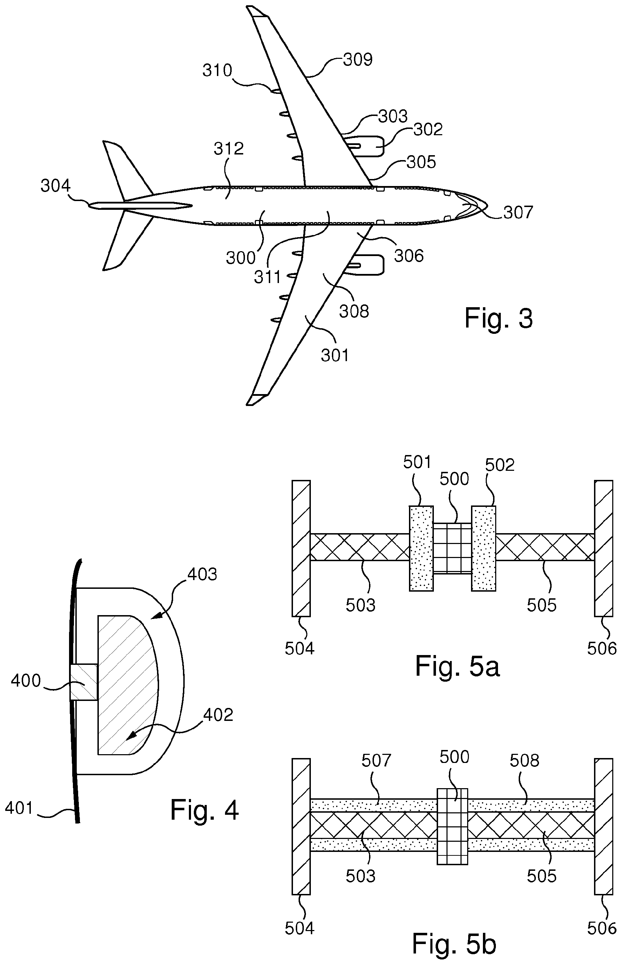

Le système 100 est disposé sur une source thermique 101 (qui peut être chaude ou froide). Par exemple, cette source thermique est une surface d'un élément d'un aéronef. Des exemples de tels éléments sont donnés en référence à la figure 3.

Pour interfacer le système avec la source de chaleur, le système comporte une couche d'interface 102. Cette couche d'interface permet d'assurer un bon transfert de flux thermique entre le système et la source thermique. Il s'agit par exemple d'une colle ou d'une pâte thermique chargée de particules conductrices thermiquement et présentant une faible résistance thermique. Une telle interface permet une installation simple et rapide sans endommager la source thermique.

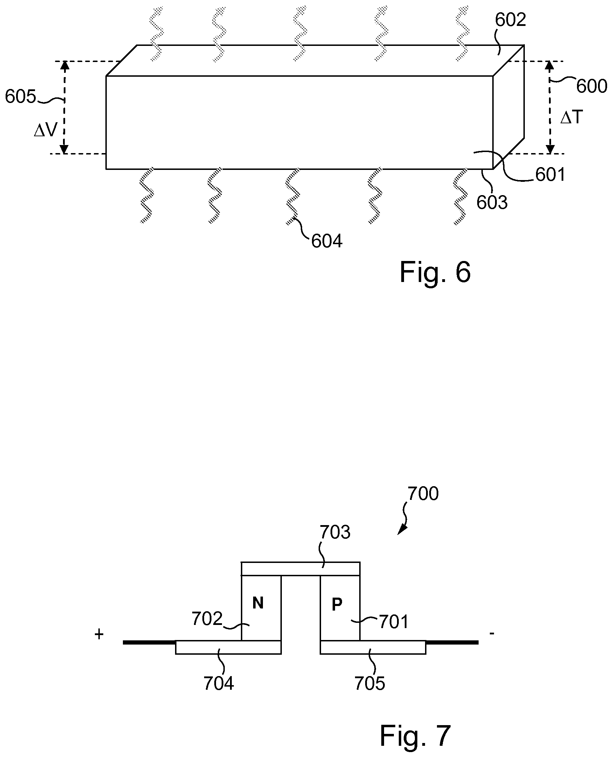

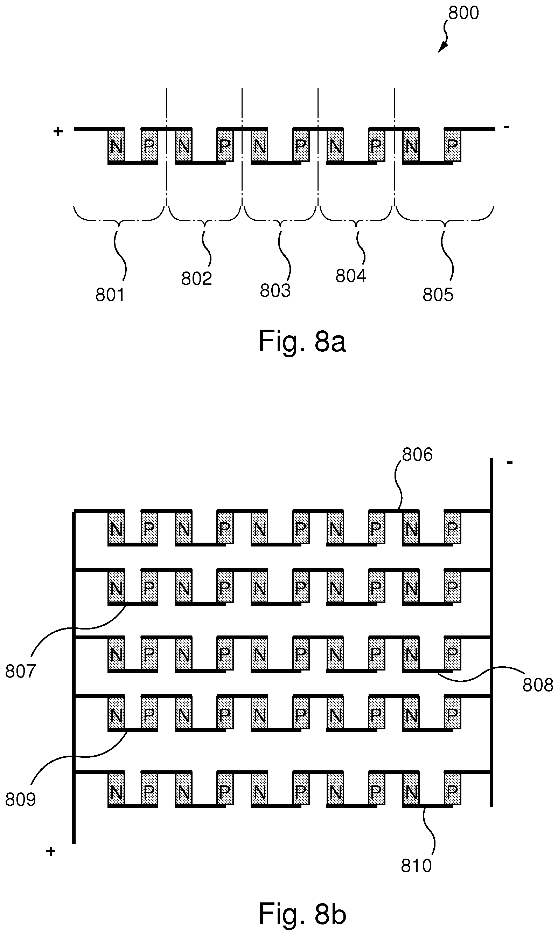

La couche d'interface est en contact thermique avec la source de chaleur d'une part, et une surface d'échange thermique du système d'autre part. Cette surface d'échange est celle d'une unité de conversion d'énergie 103 configurée pour convertir de l'énergie thermique en énergie électrique. Par exemple, cette unité compte un réseau de générateurs thermo-électriques comme il est décrit en référence aux figures 7, 8a et 8b.

Une unité à inertie thermique 104 est disposée en contact thermique avec l'unité de conversion 103. Par exemple, l'unité 104 comporte un récipient contenant un matériau à changement de phase.

Les matériaux à changement de phase sont des matériaux dont on exploite les propriétés de changement de phase (gaz/liquide/solide) en fonction de la température à laquelle ils sont soumis. Ces changements de phase sont la sublimation (passage de l'état solide à l'état gazeux), la fusion (passage de l'état solide à l'état liquide) et la vaporisation (passage de l'état liquide à l'état gazeux).

Le changement de phase s'accompagne de l'absorption (ou du rejet) de la différence d'enthalpie entre les deux phases finale et initiale. Ainsi, les matériaux à changement de phase ont une inertie thermique qui permet de ralentir les échauffements ou les refroidissements.

Des matériaux à changement de phase pouvant être utilisés sont par exemple l'eau, les métaux/alliages (le Gallium, Bi-Pb-Sn-Cd eutectique ou autre), les sels hydratés, les matériaux organiques (le polyéthylène glycol ou autre), les paraffines.

Les paraffines sont constituées de molécules linéaires d'hydrocarbures saturés à chaîne droite dont la formule chimique est du type CₙH₂ₙ₊₂. Suivant la longueur de la molécule, les paraffines peuvent être à l'état solide quand n est compris environ entre 20 et 40 (la paraffine se présente alors sous forme de cire de paraffine, à l'état liquide quand n est compris environ entre 8 et 19).

La température de fusion (Tf) des cires de paraffine est comprise généralement entre 45°C et 70°C environ suivant la composition chimique. Cependant, certaines vont au-delà, comme par exemple, la cire de paraffine de type « microcristalline » qui contient des composés à haute masse moléculaire (des hydrocarbures à branches iso-paraffiniques et des hydrocarbures naphthéniques) possède une température de fusion de l'ordre de 90°C. La chaleur spécifique (Cp) des cires de paraffine est de l'ordre de 2100 - 2900 J.kg⁻¹.K⁻¹ et leur enthalpie de fusion (ΔHf) de l'ordre de 200-220 kJ.kg⁻¹.

Les cires de paraffine (C₂₅H₅₂) constituent ainsi des matériaux convenables pour réaliser des unités à inertie thermique (par exemple pour stocker de la chaleur).

Ainsi, de manière plus générale, l'unité de conversion permet de générer une différence de potentiel électrique, à partir d'une différence de température entre sa surface d'échange avec la source thermique et sa surface en contact thermique avec l'unité 104. L'unité à inertie thermique 104 permet de retarder le retour à l'équilibre thermique de l'unité de conversion entre ses surfaces d'échange avec la source thermique et l'unité 104. Ainsi, la différence de température est maintenue durant un temps plus long, ce qui permet de générer la différence de potentielle plus longtemps et ainsi de générer une plus grande quantité d'énergie électrique. Le principe de cette conversion d'énergie est décrit plus en détails en référence à la figure 6.

L'unité de conversion 103 est connectée à un module 105 de gestion de l'énergie électrique générée. Ce module est configuré pour adapter l'énergie électrique générée à l'utilisation qui doit en être faite.

Le module de gestion 105 comporte une unité d'acquisition et de conditionnement 106.

Cette unité permet par exemple de réaliser une adaptation d'impédance. En effet, l'impédance de sortie de l'unité de conversion 103 doit être adaptée en impédance afin que le couple courant/tension soit compatible avec la charge à alimenter avec le meilleur rendement possible.

L'unité 106 peut en outre comporter un circuit « boost » (ou hacheur parallèle) pour élever la tension en sortie de l'unité 103.

Le module de gestion 105 peut en outre comporter une unité de stockage d'énergie électrique 107, par exemple afin d'offrir une réserve d'énergie tampon pour faire face à des éventuelles fluctuations de l'énergie thermique disponible à la source. Par exemple, l'énergie thermique disponible peut évoluer en fonction de la phase de vol de l'aéronef. L'unité de stockage 107 comporte par exemple des super capacités ou des batteries à film mince (« *Thin Film Batteries* » en anglais).

Le module de gestion 105 peut aussi comporter une unité de régulation 108 afin d'adapter les niveaux de tension délivrés au dispositif électrique 109 alimenté (par exemple un capteur).

Afin de réduire les pertes introduites par les composants du module de gestion, ces composants peuvent être choisis parmi la famille des composants à faible consommation de puissance. En outre, afin de réduire les dimensions du module de gestion, ces composants peuvent être disposés dans un même circuit.

Un exemple d'installation d'un système tel que décrit précédemment est présenté en référence à la **figure 2****.**

La figure 2 représente une vue partielle en coupe d'un aéronef. On retrouve une partie du fuselage 200 de l'aéronef, la partie correspondante de l'habillage intérieur 201, ainsi qu'une rangée de sièges 202.

Il est supposé qu'un capteur 203 est disposé sur le fuselage de l'aéronef. Par exemple, il s'agit d'une jauge de contrainte pour mesure les déformations du fuselage en vol. Le capteur 203 est alimenté via un module de gestion 204 (tel que décrit précédemment) par un système de conversion d'énergie 205.

Comme on peut le constater, l'encombrement dû au capteur et à son alimentation est réduit. Il ne nécessite pas de batterie autonome ou de câblage complexe. Par ailleurs, cette installation est totalement autonome et ne nécessite pas de connexion particulière à des câbles d'alimentation parcourant l'aéronef.

Un système de conversion d'énergie tel que décrit peut être installé dans diverses autres zones de l'aéronef. De telles zones sont présentées en référence à la **figure 3****.**

Les zones de l'aéronef pouvant être avantageusement utilisées sont celles dans lesquelles il existe une différence de température significative. Cela permet d'optimiser l'énergie électrique générée par l'unité de conversion (par exemple par maximalisation de l'effet Seebeck comme décrit en référence à la figure 6).

Les zones utilisées sont par exemple les zones froides telles que les structures externes du fuselage 300, des ailes 301, des surfaces mobiles, ou autre. On peut citer les cadres, les longerons, les raidisseurs, ou autre.

Les zones utilisées sont aussi par exemple les zones chaudes telles que les zones moteur 302, la zone mat 303 à l'interface de la voilure avec le moteur. Par exemple, dans la zone des pré-refroidisseurs ( « pre-coolers » en terminologie anglo-saxonne), on observe des températures d'environ 150°C. On peut aussi citer la zone 304 du moteur auxiliaire de puissance appelé APU (sigle de « *Auxiliary Power Unit »* en anglais), la zone de la machine de conditionnement d'air 305 (zone dite « pack ») qui se situe en zone non-pressurisée (bien que ventilée, la température de cette zone peut aller jusqu'à 70-80°C), les prises d'air chaud sous pression sur les moteurs 306 (les lignes de « *bleed »* en terminologie anglo-saxonne) dont la température intérieure est de l'ordre de 200°C voire 260°C ponctuellement, les zones d'entrée d'air équipées de systèmes de dégivrage chauffant, les coeurs électriques 307 (qui chauffent par effet Joule) permettant la distribution électrique dans l'aéronef, les convertisseurs de courant et tension électriques, les freins 308 sur les trains d'atterrissage (des températures jusqu'à 400°C peuvent être observées notamment en cas de RTO, sigle de « *Rejected Take-Off* » en anglais), les bords d'attaque des ailes 309 dans lesquels sont installés des routes électriques qui peuvent s'échauffer par effet Joule ainsi que des tuyaux de bleed contenant de l'air très chaud (ces zones peuvent atteindre jusqu'à 90°C). On peut aussi citer la zone locale 310 des actionneurs électro-hydrauliques en voilure pouvant présenter une température jusqu'à 110°C environ en l'absence de ventilation, les zones 311 où se situent les contrôleurs de différents systèmes (tels que pompes hydrauliques, machines thermiques, ou autre), la zone de capotage de certains rails de volet (l'échangeur thermique pour l'hydraulique pouvant se situer dans cette zone, la température peut atteindre jusqu'à 80°C dans certaines conditions de variation de pression hydraulique), la zone 312 au-dessus des porte-bagage en cabine (zone appelée « *crown* » en anglais) dans laquelle les culots des lampes sont installés (échauffement par effet Joule) et qui en plus sont isolées avec une isolation thermo-acoustique pour assurer le confort des passagers (par temps chaud, la température peut atteindre jusqu'à 60°C). Ou peut aussi citer les piles à combustible (PEMFC, SOFC, ou autre) ou encore d'autres zones.

Un mode de réalisation d'un système de conversion est décrit en référence à la **figure 4****.**

Une unité de conversion 400 est disposée contre une paroi 401 de l'aéronef. L'unité 400 est ainsi en contact thermique par sa surface d'échange avec la source thermique constituée ici par la paroi 401. Une unité à inertie thermique 402 est disposée contre l'unité de conversion en contact thermique avec celle-ci. Ainsi, une différence de température est maintenue assez longtemps pour générer de l'énergie électrique. Afin de protéger le système, une enveloppe de protection 403 enveloppe l'unité de conversion et l'unité à inertie thermique.

Le système alimente un dispositif électrique (non représenté) via un module de gestion de l'énergie électrique générée (non représenté).

Un autre mode de réalisation d'un système de conversion est décrit en référence à la **figure 5a****.**

L'unité de conversion d'énergie thermique en énergie électrique 500 est connectée thermiquement à deux unités à inertie thermique 501 et 502 par deux surfaces d'échange thermiques différentes. Un élément de connexion thermique 503, par exemple un barreau conducteur, relie l'unité 501 à une paroi 504 constituant une première source thermique. Un autre élément de connexion thermique 505 relie l'unité 502 à une autre paroi 506 constituant une deuxième source thermique.

L'utilisation des éléments de connexion permet de relier deux sources thermiques distantes mais dont les températures respectives offrent un gradient de température important, permettant ainsi une génération d'énergie électrique plus importante par l'unité de conversion 500.

Le système de la figure 5a comporte deux éléments de connexion. Cependant, il est possible de n'en prévoir qu'un seul. En outre, même dans le cas où deux éléments de connexion sont utilisés, il n'est pas nécessairement fait recours à deux unités à inertie thermique. Il est possible d'envisager qu'un élément de connexion soit associé à une unité à inertie thermique et pas l'autre.

Une variante du mode de réalisation précédent est décrite en référence à la **figure 5b****.**

Cette figure reprend les éléments communs au système de la figure 5a. Les éléments 500, 503, 504, 505 et 506 sont ainsi identiques à ceux de la figure 5a.

Dans la variante de la figure 5b, des unités à inertie thermique 507 et 508 sont à la fois en contact thermique avec l'unité de conversion 500 les sources et les éléments de connexion. Ainsi, par exemple, l'unité à inertie thermique 508 enveloppe l'élément de connexion 505 et est également en contact thermique avec l'unité 500 d'une part et la source 506 d'autre part. L'unité à inertie thermique 507 enveloppe quant à elle l'élément de connexion 503 et est également en contact thermique avec l'unité 500 d'une part et la source 504 d'autre part.

Comme pour le système de la figure 5a, le système de la figure 5b comporte deux éléments de connexion, cependant, il est possible de n'en prévoir qu'un seul. En outre, même dans le cas où deux éléments de connexion sont utilisés, il n'est pas nécessairement fait recours à deux unités à inertie thermique. Il est possible d'envisager qu'un élément de connexion soit associé à une unité à inertie thermique et pas l'autre.

Des unités de conversion thermo-électriques selon des modes de réalisation sont décrites dans ce qui suit.

De telles unités peuvent par exemple reposer sur l'effet « Seebeck ». Selon cet effet, de l'électricité peut être produite à partir d'une différence de température appliquée sur un élément dans un matériau sensible.

Lorsqu'une différence de température est appliquée sur l'élément, cela entraîne une variation de l'énergie de Fermi à travers le matériau créant ainsi une différence de potentiel qui génère un courant électrique par diffusion des charges électriques. La conductivité thermique dans le matériau s'effectue via les phonons.

Le principe général de fonctionnement d'une unité de conversion thermo-électrique (ou générateur thermo-électrique) peut être schématisé selon la **figure 6****.**

Une différence de température *Δ*T représentée par la double flèche 600 est appliquée à un barreau parallélépipédique 601 entre deux faces 602 et 603. Il est supposé que la face 602 est la face « froide » et que la face 603 est la face « chaude ». Ces faces sont dites « froide » et « chaude » en ce que la température appliquée à la face 602 (froide) est plus faible que celle appliquée à la face 603 (chaude). Ainsi, un flux thermique, représenté par des flèches 604 traverse le barreau. Par l'effet Seebeck, une différence de potentiel *Δ*V est créée entre les faces 602 et 603 représentées par la double flèche 605.

La différence de potentiel peut s'exprimer comme *A*V = S.*Δ*T, S étant le coefficient de Seebeck du matériau dans lequel est formé le barreau 601.

La puissance (P) du générateur thermo-électrique ainsi formé par le barreau auquel est appliquée la différence de température peut alors s'écrire: P = (2.S.*Δ*V)² / (4.RTEG), RTEG étant la résistance thermique du barreau.

La résistance thermique peut s'écrire RTEG = 2.n.ρ.(L₀ / A₀), où n est le nombre d'éléments formant le générateur (ici n=1), p est la résistivité électrique de l'élément, L₀ est la longueur de l'élément et A₀ est surface en section de l'élément.

Une forme de réalisation pratique d'un générateur thermo-électrique est illustrée par la **figure 7****.**

Le générateur thermo-électrique 700 de la figure 7 repose sur le principe suivant. Un élément semi-conducteur 701 dopé positivement (P) et un autre élément semi-conducteur 702 dopé négativement (N) sont placés entre une source chaude et une source froide (non représentées). Les éléments semi-conducteurs sont par exemple à base de bismuth-tellure (Bi₂Te₃) et posés sur des plaques de céramique (d'autres matériaux sont possibles, notamment : SiGe, TAGS, FeSi₂, Zn₄Sb₃, CeFe₃CoSb₁₂, Ba₈GaₓGe₄₆₋ₓ, NaCO₂O₄, Bi₂Te₃Sb₂Te₃, SiSiGe, B₄CB₃C).

Les sources sont dites « chaude » et « froide » en ce que la température de la source chaude est plus élevée que la source froide. La source froide est en contact thermique avec les faces 704 et 705 du générateur connectant les éléments semi-conducteurs respectivement 702 et 701. La source chaude est en contact thermique avec la face 703 connectée aux éléments semi-conducteurs 701 et 702.

Par l'effet Seebeck, un courant est créé par diffusion thermique des électrons et des "trous". Ainsi, la face 704 constitue la borne positive du générateur et la face 705 la borne négative.

Les générateurs thermo-électriques peuvent être connectés électriquement en série et thermiquement en parallèle. Cet assemblage 800 est représenté sur la **figure 8a****.** Il comporte cinq générateurs 801, 802, 803, 804 et 805. Il pourrait en comporter un autre nombre. Les générateurs de l'assemblage 800 ont la même structure que celle décrite en référence à la figure 7.

Ainsi, la borne négative du générateur 801 (celle connectée à l'élément semi-conducteur dopé P) est connectée à la borne positive du générateur 802 (celle connectée à l'élément semi-conducteur dopé N). La borne négative du générateur 802 est connectée à la borne positive du générateur 803. La borne négative du générateur 803 est connectée à la borne positive du générateur 804. La borne négative du générateur 804 est connectée à la borne positive du générateur 805.

La borne positive du générateur 801 forme ainsi la borne positive de l'assemblage et la borne négative du générateur 805 forme la borne négative de l'assemblage.

Les bornes positives et négatives de chaque générateur sont en contact thermique avec la même source chaude. Dans chaque générateur, la face reliant les éléments semi-conducteurs dopés N et P est en contact thermique avec la même source froide.

Pour connecter les générateurs en série électriquement comme décrit ci-dessus, une colle argent peut par exemple être utilisée.

D'autres assemblages sont possibles. Par exemple, comme illustré par la **figure 8b****,** il est possible d'associer en parallèle des sous-assemblages tels que décrits en référence à la figure 8a.

L'assemblage de la figure 8b comporte cinq sous-assemblages 806, 807, 808, 809 et 810 ayant la structure décrite en référence à la figure 8a. Un autre nombre de sous-assemblages est possible.

Les bornes positives des sous-assemblages sont connectées entre elles. Les bornes négatives des sous-assemblages sont connectées en elles. Par exemple, les bornes de tous les générateurs thermo-électriques formant les sous-assemblages sont en contact thermique avec la même source chaude. Les faces reliant deux éléments semi-conducteurs dopés N et P des générateurs thermo-électriques formant les sous-assemblages peuvent par exemple être en contact thermique avec la même source froide.

Lors l'installation de systèmes de conversion d'énergie selon des modes de réalisation l'architecture choisie peut être soit centralisée (avec un système de conversion alimentant plusieurs dispositifs électrique) soit décentralisée (avec un système de conversion alimentant chaque dispositif électrique). Ce choix peut se faire notamment en fonction des contraintes de puissance requise, de masse, de volume disponible, de propagation de panne, de ségrégation des systèmes pour respecter les exigences de sécurité, de fiabilité, de disponibilité, ou autre.

Il est également possible de choisir telle ou telle architecture en fonction des besoins de chaque dispositif électrique à alimenter.

Une unité de conversion thermo-électrique comportant un assemblage de générateurs tel que décrit ci-avant peut mesurer quelques millimètres carrés.

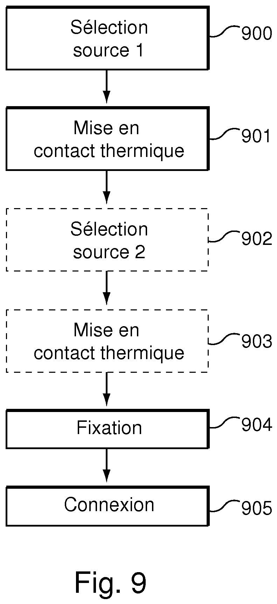

L'installation d'un système selon des modes de réalisation pour alimenter un dispositif électrique dans un aéronef peut se faire conformément au procédé décrit en référence à l'organigramme de la **figure 9****.**

Lors d'une première étape 900, une source thermique est sélectionnée afin de créer un gradient de température dans le système de conversion d'énergie. Cette source thermique peut être un élément de structure de l'aéronef. Elle peut être choisie parmi celles décrites en référence à la figure 3. Par exemple, cette source thermique est une source à forte température (zone moteur ou autre) ou une source à faible température (habillage de l'aéronef ou autre).

Lors d'une étape 901, la source thermique sélectionnée est mise en contact thermique avec une surface d'échange de l'unité de conversion d'énergie. Par exemple, cette source est mise en contact avec des faces d'un ensemble de générateurs thermo-électriques tels que décrits précédemment. Cette mise en contact peut par exemple se faire via un élément de connexion thermique comme décrit en référence aux figures 5a et 5b ou en utilisant une pâte thermique améliorant le contact thermique.

Un système utilisant une seule source thermique, tel que celui décrit en référence à la figure 4 peut être utilisé. L'énergie électrique est alors générée par la différence de température entre celle de la source thermique et la température ambiante dans laquelle le système est plongé.

De manière optionnelle, une autre source thermique peut être sélectionnée lors d'une étape 902. Il s'agit par exemple de sélectionner une source thermique dont la température est très différente de la température de la source sélectionnée lors de l'étape 900. Il est ainsi possible d'optimiser la différence de température au sein de l'unité de conversion du système. Le choix d'une deuxième source thermique peut se faire en fonction de la localisation dans l'aéronef et du dispositif à alimenter. Une grande différence de température peut permettre de générer une plus grande quantité d'énergie. On peut ainsi alimenter un dispositif électrique de plus grande consommation.

Lors d'une étape 903, la deuxième source thermique sélectionnée lors de l'étape 902 est connectée à une autre surface d'échange de l'unité de conversion.

Lors d'une étape 904, le système est fixé, par exemple au moyen d'une colle ou d'un moyen de fixation temporaire. Alternativement, le système peut simplement être disposé dans un boîtier à proximité du dispositif à alimenter.

Le système est ensuite connecté électriquement au dispositif électrique à alimenter lors d'une étape 905.

Un système selon des modes de réalisation peut être monté sur la paroi interne d'un fuselage d'aéronef. Plusieurs contraintes peuvent alors être prises en compte.

Le montage (et le démontage) du système doit être rapide. Ainsi, un principe de montage (et de démontage) simple est préférable, en particulier dans le contexte de d'installation du système pour une instrumentation aisée d'un aéronef d'essais en vol pour de très courtes campagnes de tests.

Le montage (et le démontage) du système doit être fiable. En particulier le principe de montage doit être compatible avec les ambiances vibratoires d'un aéronef. Il convient en effet d'éviter que le système ne se détache de la paroi.

En outre, le principe de montage du système ne doit pas endommager la paroi sur laquelle il est monté.

A côté de ces contraintes de montage, comme expliqué ci-avant dans la description, la résistance thermique doit être minimisée pour optimiser la puissance disponible en sortie du système.

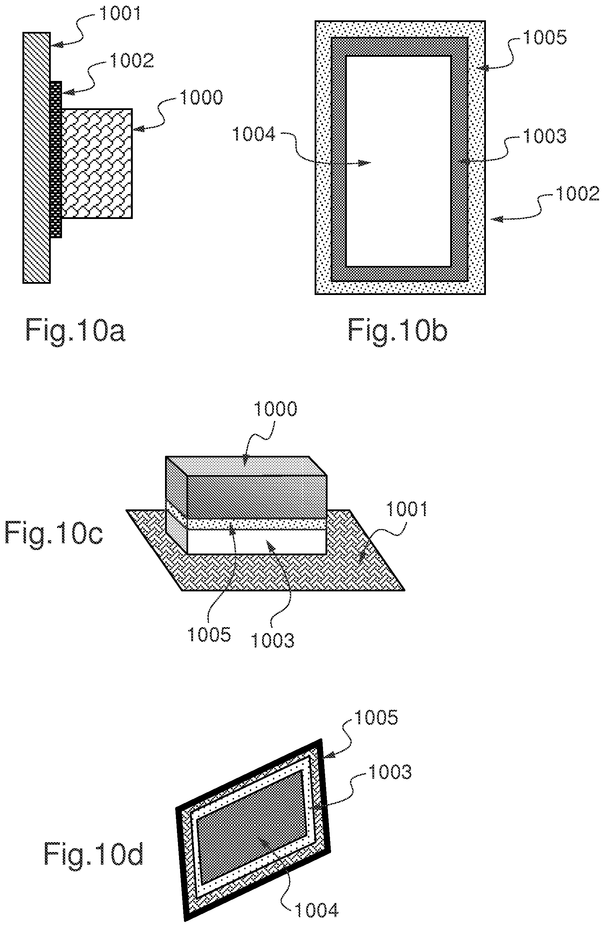

La **figure 10a** est une illustration générale de la fixation d'un système selon des modes de réalisation. Un système de conversion 1000 est fixé à une paroi intérieure 1001 d'un fuselage d'aéronef au moyen d'une interface de fixation 1002.

Dans le montage de la figure 10a, la résistance thermique totale est la somme de la résistance thermique du fuselage, de la résistance thermique de l'interface et de la résistance thermique du système de conversion.

L'interface peut comporter une superposition de deux couches de matériaux comme illustré par la **figure 10b****.** L'interface peut permettre la fixation d'un seul système ou d'un tout autre nombre.

Une première couche de matériau 1005 comporte une plaque métallique de montage sur aéronef (exemple, plaque type AU4G)..

Une deuxième couche est disposée entre la paroi intérieure 1001 et la première couche 1005. Cette deuxième couche est choisie pour obtenir un bon compromis en termes de fixation et de conductivité thermique (par exemple 3 W.m⁻¹.K⁻¹). Elle minimise ainsi la résistance thermique de l'interface de fixation et celle de l'ensemble. La deuxième couche a par exemple des dimensions de 70x50 mm.

Par exemple, la deuxième couche comporte elle-même une couche bi-matériaux 1003 et 1004.

La sous-couche de matériau 1004 a par exemple les caractéristiques physiques suivantes: masse volumique de 2700-3700 kg/m³, un module de Young de 0,15-0,21 MPa, une capacité thermique de 500-1500 J.kg⁻¹.K⁻¹, une gamme de température dans la gamme 223-463 K, une résistivité électrique de 10⁸-10⁹ Ω.m et une tension de rupture diélectrique supérieure à 2800 V AC. Le GAP PAD 3000S est un exemple de matériau répondant à ces caractéristiques.

La sous-couche de matériau 1003 est par exemple disposée autour de la sous-couche de matériau 1004. La sous-couche de matériau 1003 permet d'assurer la rapidité de montage et la fiabilité vis-à-vis de l'environnement aéronef. Il s'agit par exemple d'un ruban à double faces adhésives. Ce ruban a par exemple la même épaisseur que la sous-couche de matériau 1004. Ce ruban a par exemple une largeur de 5 mm.

La **figure 10c** est une vue plongeante de côté du système monté. Dans cette vue, la sous-couche de matériau 1004 n'apparait pas car elle est entourée par la sous-couche 1003.

La sous-couche 1004 apparait en revanche dans la vue de dessous de la **figure 10d****.**

D'après ces deux vues, il apparait que la sous-couche de matériau 1003 est disposée sur le pourtour du système de conversion, laissant ainsi une surface intérieure au pourtour libre pour accueillir la sous-couche 1004. D'une manière générale, la sous-couche 1003 est disposée autour de la sous-couche 1004. Les deux sous-couches ayant la même épaisseur, lorsque le système est monté sur la paroi, la sous-couche 1004 est bien en contact thermique avec celle-ci et la sous-couche 1003 est également bien en contact avec la paroi pour permettre la fixation.

Les deux sous-couches de matériau peuvent être intégrées dans un même patch prêt à l'emploi, afin de permettre un montage encore plus aisé. Ce patch est par exemple adapté aux dimensions des systèmes de conversion utilisés dans les aéronefs.

Le patch peut avoir la forme d'un rouleau qu'un utilisateur peut dérouler pour découper une bandelette adhésive avec matériau conducteur thermiquement, à coller sur un système de conversion pour ensuite le fixer sur une paroi.

La présente invention a été décrite et illustrée dans la présente description détaillée en référence aux figures jointes. Toutefois la présente invention ne se limite pas aux formes de réalisation présentées. D'autres variantes, modes de réalisation et combinaisons de caractéristiques peuvent être déduits et mis en oeuvre par la personne du métier à la lecture de la présente description et des figures annexées.

Pour satisfaire des besoins spécifiques, une personne compétente dans le domaine de l'invention pourra appliquer des modifications ou adaptations.

Dans les revendications, le terme "comporter" n'exclut pas d'autres éléments ou d'autres étapes. L'article indéfini « un » n'exclut pas le pluriel. Un seul processeur ou plusieurs autres unités peuvent être utilisées pour mettre en oeuvre l'invention. Les différentes caractéristiques présentées et/ou revendiquées peuvent être avantageusement combinées. Leur présence dans la description ou dans des revendications dépendantes différentes, n'exclut pas en effet la possibilité de les combiner. Les signes de référence ne sauraient être compris comme limitant la portée de l'invention.

## Revendications

1. Système de conversion d'énergie (100, 205), comportant :
- une unité de conversion (103, 400, 500, 600, 700, 800) pour convertir de l'énergie thermique en énergie électrique, ladite unité comportant au moins une surface d'échange thermique (703, 704, 705) pour échanger de l'énergie thermique avec au moins une source thermique extérieure (101, 200, 401, 504, 506),
- une unité à inertie thermique (104, 402, 501, 502, 507, 508) configurée pour coopérer avec l'unité de conversion pour ralentir un retour à un équilibre thermique de l'unité de conversion lors de l'échange d'énergie thermique, et
- au moins un premier élément de connexion thermique (503) qui est un barreau conducteur en contact thermique avec une première surface d'échange thermique de l'unité de conversion, ledit premier élément étant configuré pour guider un transfert thermique entre une première source thermique extérieure (504) et ladite première surface d'échange thermique.

2. Système selon la revendication 1, dans lequel ladite unité à inertie thermique comporte un matériau à changement de phase.

3. Système selon la revendication 1 ou la revendication 2, isolé par une enveloppe de protection (403), ladite au moins une surface d'échange thermique restant libre pour l'échange thermique.

4. Système selon l'une des revendications précédentes, comportant en outre une unité de stockage (107) pour stocker, au moins en partie, l'énergie électrique convertie.

5. Système selon l'une des revendications précédentes, comportant au moins un deuxième élément de connexion thermique (505) en contact thermique avec une deuxième surface d'échange thermique de l'unité de conversion, ledit deuxième élément étant configuré pour guider un transfert thermique entre une deuxième source thermique extérieure (506) et ladite deuxième surface d'échange thermique.

6. Système selon la revendication 5, dans lequel ladite unité de conversion thermique est connectée thermiquement à deux unités à inertie thermique par lesdites première et deuxième surfaces d'échange thermique respectivement.

7. Système selon la revendication 6, dans lequel une des unités à inertie thermique enveloppe le premier élément de connexion thermique et l'autre des unités à inertie thermique enveloppe le deuxième élément de connexion thermique.

8. Système selon l'une des revendications 5 à 7, dans lequel lesdites première et deuxième sources thermiques sont des sources thermiques distantes.

9. Système selon l'une des revendications précédentes, dans lequel ladite au moins une surface d'échange est au moins en partie recouverte d'une couche d'interface de conduction thermique avec ladite au moins une source thermique.

10. Système selon la revendication 9, dans lequel ladite couche d'interface comporte une sous-couche (1003) de ruban à double surface adhésive.

11. Système selon la revendication 10, dans lequel ledit ruban à double surface adhésive est disposé autour d'une sous-couche (1004) de matériau de conduction thermique.

12. Système selon la revendication 11, dans lequel lesdites sous-couches de ruban à double surface adhésive et de matériau de conduction thermique ont une même épaisseur.

13. Système selon la revendication 11 ou la revendication 12, dans lequel lesdites sous-couches de ruban à double surface adhésive et de matériau de conduction thermique sont intégrées dans un même élément d'interface indépendant.

14. Aéronef comportant un système selon l'une des revendications précédentes.

15. Aéronef selon la revendication 14, dans lequel ladite au moins une source thermique est choisie parmi les éléments de structure de l'aéronef.

16. Aéronef selon la revendication 14 ou la revendication 15, dans lequel le système alimente au moins un capteur en énergie électrique.

17. Procédé d'alimentation électrique d'un dispositif électrique dans un aéronef, comportant les étapes suivantes de :
- sélection (900, 902) d'au moins une source thermique dans l'aéronef,
- mise en contact thermique (901, 903) d'au moins une surface d'échange d'une unité de conversion d'un système selon l'une des revendications 1 à 13 à ladite au moins une source thermique sélectionnée, et
- connexion (905) dudit système audit dispositif électrique,
ladite mise en contact thermique comportant la mise en contact thermique d'au moins le premier élément de connexion thermique (503) qui est un barreau conducteur avec la première surface d'échange thermique de l'unité de conversion, ledit premier élément étant configuré pour guider un transfert thermique entre la première source thermique extérieure (504) et ladite première surface d'échange thermique.

18. Procédé selon la revendication 17, dans lequel ladite au moins une source thermique est sélectionnée parmi les éléments de structure de l'aéronef.

## Patentansprüche

1. Energieumwandlungssystem (100, 205), umfassend:
- eine Umwandlungseinheit (103, 400, 500, 600, 700, 800), um Wärmeenergie in elektrische Energie umzuwandeln, wobei die Einheit mindestens eine Wärmeaustauschfläche (703, 704, 705) umfasst, um Wärmeenergie mit mindestens einer externen Wärmequelle (101, 200, 401, 504, 506) auszutauschen,
- eine Wärmeträgheitseinheit (104, 402, 501, 502, 507, 508), die dazu konfiguriert ist, mit der Umwandlungseinheit zusammenzuwirken, um eine Rückkehr zu einem Wärmegleichgewicht der Umwandlungseinheit beim Wärmeenergieaustausch zu verlangsamen, und
- mindestens ein erstes Wärmeanschlusselement (503), das ein Leiterstab ist, der mit einer ersten Wärmeaustauschfläche der Umwandlungseinheit in Wärmekontakt steht, wobei das erste Element dazu konfiguriert ist, eine Wärmeübertragung zwischen einer ersten externen Wärmequelle (504) und der ersten Wärmeaustauschfläche zu leiten.

2. System nach Anspruch 1, bei dem die Wärmeträgheitseinheit ein Phasenwechselmaterial umfasst.

3. System nach Anspruch 1 oder Anspruch 2, das durch eine Schutzhülle (403) isoliert ist, wobei die mindestens eine Wärmeaustauschfläche für den Wärmeaustausch frei bleibt.

4. System nach einem der vorhergehenden Ansprüche, ferner umfassend eine Speichereinheit (107), um zumindest teilweise die umgewandelte elektrische Energie zu speichern.

5. System nach einem der vorhergehenden Ansprüche, mindestens umfassend ein zweites Wärmeanschlusselement (505) in Wärmekontakt mit einer zweiten Wärmeaustauschfläche der Umwandlungseinheit, wobei das zweite Element dazu konfiguriert ist, eine Wärmeübertragung zwischen einer zweiten externen Wärmequelle (506) und der zweiten Wärmeaustauschfläche zu leiten.

6. System nach Anspruch 5, bei dem die Wärmeumwandlungseinheit thermisch an zwei Wärmeträgheitseinheiten durch die ersten bzw. zweiten Wärmeaustauschflächen angeschlossen ist.

7. System nach Anspruch 6, bei dem eine der Wärmeträgheitseinheiten das erste Wärmeanschlusselement umhüllt, und die andere der Wärmeträgheitseinheiten das zweite Wärmeanschlusselement umhüllt.

8. System nach einem der Ansprüche 5 bis 7, bei dem die ersten und zweiten Wärmequellen entfernte Wärmequellen sind.

9. System nach einem der vorhergehenden Ansprüche, bei dem die mindestens eine Austauschfläche zumindest teilweise von einer Wärme leitenden Schnittstellenschicht mit der mindestens einen Wärmequelle bedeckt ist.

10. System nach Anspruch 9, bei dem die Schnittstellenschicht eine Unterschicht (1003) aus Doppelklebeband umfasst.

11. System nach Anspruch 10, bei dem das Doppelklebeband um eine Unterschicht (1004) aus einem Wärme leitenden Material angeordnet ist.

12. System nach Anspruch 11, bei dem die Unterschichten aus Doppelklebeband und aus Wärme leitendem Material eine selbe Dicke aufweisen.

13. System nach Anspruch 11 oder Anspruch 12, bei dem die Unterschichten aus Doppelklebeband und aus Wärme leitendem Material in ein selbes unabhängiges Schnittstellenelement integriert sind.

14. Flugzeug, umfassend ein System nach einem der vorhergehenden Ansprüche.

15. Flugzeug nach Anspruch 14, bei dem die mindestens eine Wärmequelle unter den Strukturelementen des Flugzeugs ausgewählt ist.

16. Flugzeug nach Anspruch 14 oder Anspruch 15, bei dem das System mindestens einen Sensor mit elektrischer Energie versorgt.

17. Verfahren zur elektrischen Versorgung einer elektrischen Vorrichtung in einem Flugzeug, umfassend die folgenden Schritte:
- Auswahl (900, 902) mindestens einer Wärmequelle im Flugzeug,
- thermische Kontaktnahme (901, 903) mindestens einer Wärmeaustauschfläche einer Umwandlungseinheit eines Systems nach einem der Ansprüche 1 bis 13 mit mindestens einer ausgewählten Wärmequelle, und
- Anschluss (905) des Systems an die elektrische Vorrichtung,
wobei die thermische Kontaktnahme die thermische Kontaktnahme mindestens des ersten Wärmeanschlusselements (503), das ein Leiterstab ist, mit der ersten Wärmeaustauschfläche der Umwandlungseinheit umfasst, wobei das erste Element dazu konfiguriert ist, eine Wärmeübertragung zwischen der ersten externen Wärmequelle (504) und der ersten Wärmeaustauschfläche zu leiten.

18. Verfahren nach Anspruch 17, bei dem die mindestens eine Wärmequelle unter den Strukturelementen des Flugzeugs ausgewählt ist.

## Claims

1. Energy conversion system (100, 205), comprising:
- a conversion unit (103, 400, 500, 600, 700, 800) for converting thermal energy into electrical energy, said unit comprising at least one thermal exchange surface (703, 704, 705) for exchanging thermal energy with at least one external thermal source (101, 200, 401, 504, 506),
- a thermal inertia unit (104, 402, 501, 502, 507, 508) configured to cooperate with the conversion unit to slow down the return of the conversion unit to a thermal balance upon the exchange of thermal energy, and
- at least one first thermal connection element (503) which is a conductor bar in thermal contact with a first thermal exchange surface of the conversion unit, said first element being configured to guide a heat transfer between a first external thermal source (504) and said first thermal exchange surface.

2. System according to claim 1, in which said thermal inertia unit comprises a phase-change material.

3. System according to claim 1 or claim 2, insulated by a protection jacket (403), said at least one thermal exchange surface remaining free for the thermal exchange.

4. System according to one of the preceding claims, further comprising a storage unit (107) for storing, at least partly, the converted electrical energy.

5. System according one of the preceding claims, comprising at least one second thermal connection element (505) in thermal contact with a second thermal exchange surface of the conversion unit, said second element being configured to guide a heat transfer between a second external thermal source (506) and said second thermal exchange surface.

6. System according to claim 5, in which said thermal conversion unit is thermally connected to thermal inertia units by said first and second thermal exchange surfaces respectively.

7. System according to claim 6, in which one of the thermal inertia units envelops the first thermal connection element and the other of the thermal inertial units envelops the second thermal connection element.

8. System according to one of claims 5 to 7, in which said first and second thermal sources are remote thermal sources.

9. System according to one of the preceding claims, in which said at least one exchange surface is at least partly covered with an interface layer for thermal conduction with said at least one thermal source.

10. System according to claim 9, in which said interface layer comprises a sublayer (1003) of double-sided adhesive tape.

11. System according to claim 10, in which said double-sided adhesive tape is positioned around a sublayer (1004) of thermal conduction material.

12. System according to claim 11, in which said sublayers of double-sided adhesive tape and of thermal conduction material have one and the same thickness.

13. System according to claim 11 or claim 12, in which said sublayers of double-sided adhesive tape and of thermal conduction material are incorporated in one and the same independent interface element.

14. Aircraft comprising a system according to one of the preceding claims.

15. Aircraft according to claim 14, in which said at least one thermal source is chosen from the structural elements of the aircraft.

16. Aircraft according to claim 14 or claim 15, in which the system supplies at least one sensor with electrical energy.

17. Method for supplying electrical power to an electrical device in an aircraft, comprising the following steps of:
- selection (900, 902) of at least one thermal source in the aircraft,
- thermal contact (901, 903) of at least one exchange surface of a conversion unit of a system according to one of claims 1 to 8 with said at least one selected thermal source, and
- connection (905) of said system to said electrical device, said thermal contact comprising the thermal contact of at least the first thermal connection element (503) which is a conductor bar with the first thermal exchange surface of the conversion unit, said first element being configured to guide a heat transfer between the first external thermal source (504) and said first thermal exchange surface.

18. Method according to claim 17, in which said at least one thermal source is selected from the structural elements of the aircraft.
